Europäisches Patentamt

European Patent Office

Office européen des brevets

(11) Publication number: **0 238 118**
A2

## EUROPEAN PATENT APPLICATION

(21) Application number: 87200298.5

(22) Date of filing: 24.02.87

(51) Int. Cl.⁴: **H05K 1/11** , H01L 21/60

(30) Priority: 19.03.86 IT 1980386

(43) Date of publication of application:
23.09.87 Bulletin 87/39

(84) Designated Contracting States:
BE DE ES FR GB GR IT NL

(71) Applicant: GTE TELECOMUNICAZIONI S.P.A.
SS. 11 Padana Superiore Km. 158
I-20060 Cassina de Pecchi (Milano)(IT)

(72) Inventor: Bassani, Carla
Vicolo Monetti, 7
I-21046 Malnate (Varese)(IT)
Inventor: Villa, Carlo
Via Buozzi, 11
I-21012 Cassano Magnago (Varese)(IT)
Inventor: Ziboni, Maurizio
Via Leonardo da Vinci 9
I-20060 Pessano con Bornago (Milano)(IT)

(74) Representative: Mittler, Enrico et al
c/o Marchi & Mittler s.r.l. Viale Lombardia, 20
I-20131 Milano(IT)

(54) **Process for making metallized holes in a substrate having conductive and resistive paths and the product obtained by said process.**

(57) The process calls for drilling a flat substrate (1) having conductive and resistive paths (2) and then repeated washing thereof. After drying, a substance capable of promoting adhesion is deposited. A thin layer of copper (4) is then deposited on the entire surface of the substrate and after masking galvanic growth of copper (6) in the holes (3) and in the immediately adjacent areas is performed. The chemically deposited copper (4) is finally removed from the areas previously masked.

*Fig. 6*

**"Process for making metallized holes in a substrate having conductive and resistive paths and the product obtained by said process"**

The present invention relates to a process for making metallized holes in a substrate having conductive and resistive paths as well as the product obtained by said process.

To produce hybrid circuits on an oxide substrate the technique which calls for making the circuit connection between the faces, both metallized, of the substrate through metal-coated holes which pass through said substrate is known in itself.

In this manner the mechanical connection of active components to the substrate and to the associated surface metallizations is simpler and more economical compared with the conventional bolting method and the electrical connection is also more effective and accurate. In particular in microwave circuits it assures connection of the active components to a "cold ground".

But the problem is how and when to perform the drilling of the substrate. If it is done before application of the conductive and resistive paths there are no functional problems but industrial production must provide stocks differentiated according to the various possible hole patterns required for the individual circuits. On the other hand if drilling is performed after applic ation of the conductive and resistive paths it becomes difficult to avoid disturbing the physical state of said paths when drilling.

The particular utility of the above technique for making circuits of interest at present such as thin film hybrid circuits on an alumina substrate was recently pointed out.

The object of the present invention is to conceive a process which would allow making metallized holes in a substrate already having conductive and resistive paths without changing the physical state in such a manner as to assure industrial and commercial benefits without having to suffer from functional drawbacks.

In accordance with the invention said object is achieved by a process characterized in that it comprises the following steps in the order given: drilling of a flat substrate having conductive and resistive paths; repeated washing, first rough, then fine, of the drilled substrate to eliminate drilling debris and prepare the circuit for the next treatment; drying of the circuit; depositing of a substance capable of promoting adhesion on the entire surface of the two faces of the metallized substrate; another drying of the circuit; chemical deposit of a thin layer of copper over the entire surface of the two faces of the substrate; another drying of the circuit; masking of both faces of the substrate excepting the holes and the immediately adjacent areas; galvanic growth of copper in the unmasked areas; removal of the mask; and chemical removal of chemically deposited copper from the previously masked areas of the substrate.

It has been found that the process in accordance with the invention makes it possible to give to substrates already having conductive and resistive paths appropriately metallized holes without changing in some way the physical state of said paths. This makes it possible to mass-produce the circuit with minimal stocks on hand adaptable to individual requirements.

In particular the process in accordance with the invention has proved to be useful in the making of metallized holes in thin film hybrid circuits on an alumina substrate. In this case highly satisfactory results were obtained by performing the rough washing of the circuit with ultrasounds and deionized water and the fine washing with ultrasounds and ammonium bifluoride and using organosilane as a substance capable of promoting adhesion. This washing method makes possible perfect preparation of the circuit before metallization of the holes in the form of a high degree of cleanliness of the surface and holes of the substrate and because the ammonium bifluoride gives rise to hydrofluoric acid which activates the surface which is to be metallized with copper. Organosilane is a substance capable of giving excellent adhesiveness to the surface which re ceives it and hence of facilitating adhesion of the copper subsequently deposited chemically thereon.

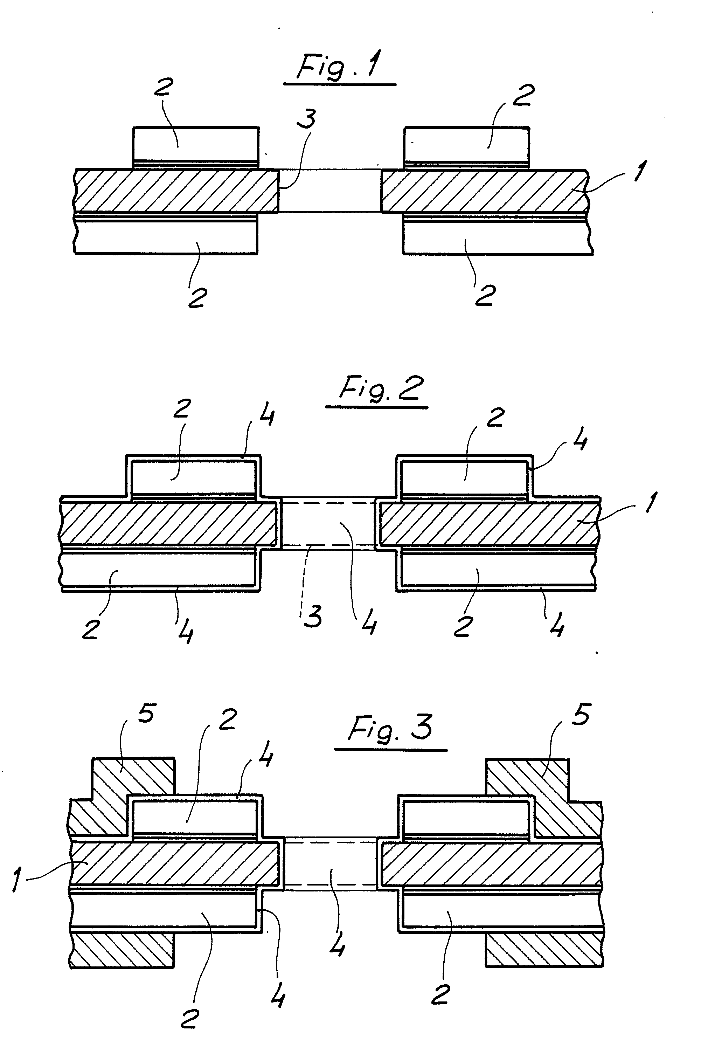

These and other characteristics of the present invention will be made clear by the following description set forth as a nonlimiting example of a process for thin film hybrid circuits on an alumina substrate the principal steps of which are illustrated in FIGS. 1-6 of the annexed drawing which show a cross section of a through hole.

As can be seen from FIG. 1 a flat substrate 1 of alumina (or some other metallic oxide) having thin film conductive paths 2, e.g. of gold, is initially drilled to create the through holes 3. The drilling is preferably performed with a laser beam.

The circuit (substrate 1 with conductive paths 2) is subsequently subjected to a first rough washing with ultrasounds and deionized water and a second fine washing with ultrasounds and ammonium bifluoride. Finally a washing and drying in centrifugation of nitrogen follow. This provides a high degree of surface cleanliness and eliminates any alumina debris from the holes 3. The ammonium bifluoride also gives rise to hydrofluoric acid which activates the alumina surface for the subsequent metallization.

Then the circuit is dried in an oven at 80°C for approximately thirty minutes to eliminate all traces of moisture.

Organosilane (a substance capable of promoting adhesion) is then deposited on the entire surface of the two faces of the circuit including the holes. This operation is performed in a vapour-saturated environment to secure a uniform deposit.

Another period of drying in an oven at 90°C for approximately one hour follows.

A thin layer of copper 4, e.g. from 0.3 to 0.4 microns, is deposited chemically on the entire surface prepared as above, thus on the two faces of the circuit and in the holes 3. The circuit now appears as shown in FIG. 2.

Now another drying in an oven at 130°C for from 2 to 4 hours is performed.

The dried circuit is then protected with a negative resist mask 5 applied by spraying (FIG. 3) which leaves uncovered only the holes 3 and the immediately adjacent areas on both faces of the circuit. Other areas which might be reserved for the growth of other conductive and/or resistive paths may be left free if desired.

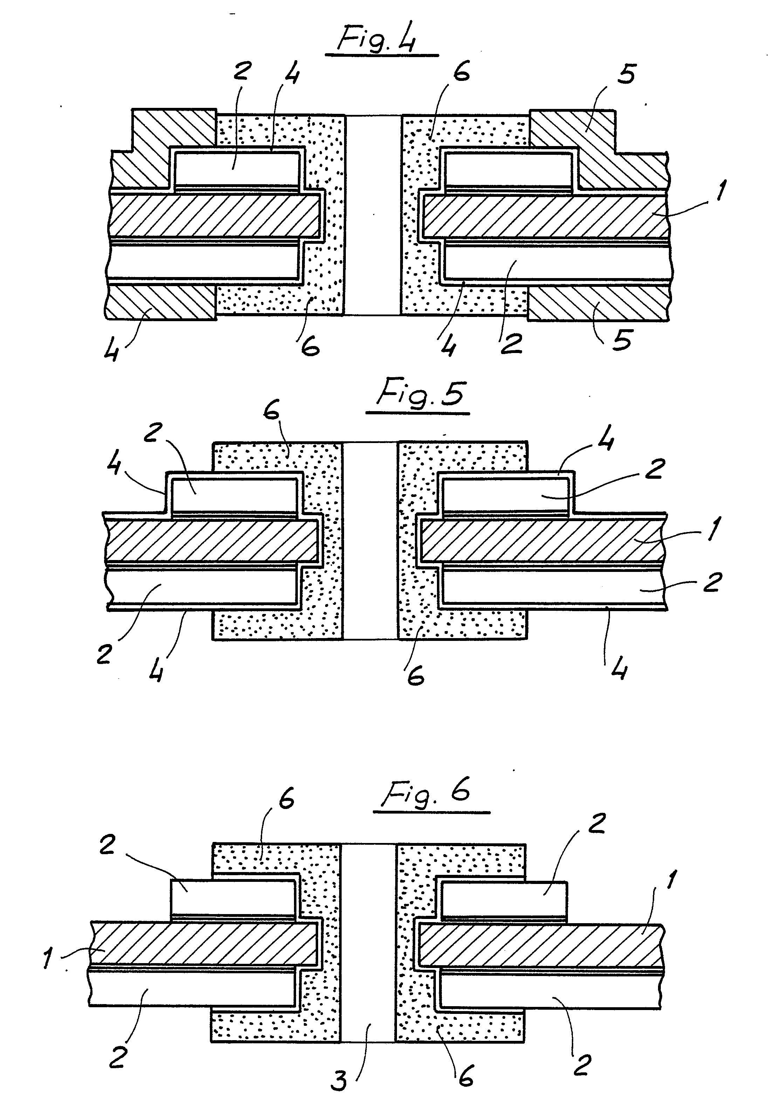

A thicker layer of copper 6 (e.g. 7 to 8 microns) is grown galvanically in the unprotected areas, i.e. in the holes 3 and in the immediately ajacent areas (plus any other areas reserved for copper paths) as shown in FIG. 4.

The resist 5 is then eliminated chemically by means of a suitable solvent. The circuit is now in the state shown in FIG. 5.

Finally the copper 4 is removed chemically from the areas previously protected by the resist 5, i.e. all the chemical copper 4 with the exception of that now covered by the galvanic copper 6. An acqueous solution of ammonium persulphate is preferably used for the etching.

The circuit thus treated is finally in the state illustrated in FIG. 6, i.e. with an alumina substrate 1 having thin film conductive paths 2 and through holes 3 with metallizations 6 for mechanical and electrical connection of the active components.

## Claims

1. Process for making metallized holes in a substrate having conductive and resistive paths characterized in that it comprises in succession the following steps: drilling of a flat substrate (1) having conductive and resistive paths (2); repeated washing, first rough and then fine, of the drilled substrate to eliminate drilling debris and prepare the circuit for the next treatment; drying of the circuit; deposit of a substance capable of promoting adhesion on the entire surface of the two faces of the metallized substrate; another drying of the circuit; chemical deposit of a thin layer of copper (4) on the entire surface of the two faces of the substrate (1); another drying of the circuit; masking of the two faces of the substrate (1) excepting the holes - (3) and the immediately adjacent areas; galvanic growth of the copper (6) in the unmasked areas; removal of the mask (5); and chemical removal of the chemically deposited copper (4) from the areas of the substrate previously masked.

2. Process in accordance with claim 1 characterized in that said conductive and resistive paths of the flat substrate are built up of thin film.

3. Process in accordance with claim 1 characterized in that said conductive and resistive paths of the flat substrate are built up of thick film.

4. Process in accordance with claim 1 characterized in that said repeated washing comprises a rough washing with ultrasounds and deionized water and a fine washing with ultrasounds and ammonium bifluoride.

5. Process in accordance with claim 1 characterized in that said substance capable of promoting adhesion is organosilane.

6. Process in accordance with claim 5 characterized in that said substance is deposited in a vapour-saturated environment.

7. Process in accordance with claim 1 characterized in that said drilling is performed with a laser beam.

8. Process in accordance with claim 1 charaterized in that said masking is performed with negative resist (5).

9. Product obtained by the process in accordance with claim 1 characterized in that it consists of a hybrid circuit with a flat substrate of metallic oxide (1) having conductive paths (2) on both faces and passed through by holes (3) having coating metallizations (6).

10. Product in accordance with claim 9 characterized in that it consists of a hybrid circuit having thin film conductive paths (2) on an alumina substrate (1) having holes (3) with coating metallizations (6).

11. Product in accordance with claim 9 characterized in that it consists of a hybrid circuit having thick film conductive paths (2) on an alumina substrate (1) having holes (3) with coating metallizations (6).

_Fig.1_

_Fig.2_

_Fig.3_

_Fig. 4_

_Fig. 5_

_Fig. 6_